Europäisches Patentamt

European Patent Office

Office européen des brevets

(19)

(11) Publication number: **0 352 916**
**A2**

# (12) EUROPEAN PATENT APPLICATION

(21) Application number: **89306730.6**

(22) Date of filing: **03.07.89**

(51) Int. Cl.4: **H01L 29/36 , H01L 29/91 , H01L 47/02**

The title of the invention has been amended (Guidelines for Examination in the EPO, A-III, 7.3).

(30) Priority: **22.07.88 GB 8817459**

(43) Date of publication of application:
**31.01.90 Bulletin 90/05**

(84) Designated Contracting States:
**DE FR**

(71) Applicant: **THE GENERAL ELECTRIC COMPANY, p.l.c.**
**1 Stanhope Gate**
**London W1A 1EH(GB)**

(72) Inventor: **Davies, Richard Alun**
**28 The Leys**
**Long Buckby Northamptonshire NN6 7YD(GB)**
Inventor: **Kearney, Michael John**
**26 Berkeley Square Woodhall Farm**
**Hemel Hempstead Hertfordshire, HP2 7QR(GB)**

(74) Representative: **George, Sidney Arthur**
**The General Electric Company p.l.c. GEC Patent Department(Wembley Office) Hirst Research Centre East Lane**
**Wembley Middlesex, HA9 7PP(GB)**

(54) **Planar doped barrier semiconductor devices.**

(57) A planar doped barrier structure for use, for example, in a Gunn oscillator, comprises, in a stack, a first doped semiconductor layer (3) of a first conductivity type, an intermediate layer (4) of semiconductor material, a doped semiconductor layer (5) of the other conductivity type which is substantially fully depleted, and a second doped semiconductor layer (7) of the first conductivity type. The doping density of the first doped semiconductor layer is different from that of the second doped semiconductor layer, so that an asymmetrical device is produced in which the potential barrier height which is encountered, for zero bias, in one direction across the barrier is different from that encountered in the opposite direction. This allows the forward characteristics of a diode structure to be significantly improved, without necessarily changing the reverse characteristic. A further intermediate layer (6) may be formed between the layer (5) of other conductivity type and the second doped semiconductor layer (7). The intermediate layer or layers may be substantially undoped, or may be slightly doped to be of the first conductivity type, in order to reduce the resistance of the device.

## Semiconductor Devices

This invention relates to semiconductor devices, and particularly to semiconductor devices of the planar doped barrier type for use, for example, at microwave frequencies.

Planar doped barrier structures have previously been proposed for use in microwave devices, such as Gunn oscillators. Such structures conventionally comprise a thin layer of p-type material which is sandwiched between two undoped semiconductor layers, which are, in turn, sandwiched between two heavily-doped n-type layers, to form an $n^+$-i-p-i-$n^+$ structure. The thickness of the undoped layers and the acceptor charge density are selected to give a required potential barrier height, and the ratio of the thickness of the undoped layers can be selected to determine the position of the peak in the potential profile.

However, for zero bias voltage the effective barrier height encountered from one side of the barrier has always been the same as that encountered from the other side of the barrier.

It is an object of the present invention to provide an improved planar doped barrier structure, in which the potential barrier height which is encountered, for zero bias, in one direction across the barrier is different from that encountered in the opposite direction.

According to the invention there is provided a planar doped barrier structure, comprising, in a stack, a first doped semiconductor layer of one conductivity type; an intermediate layer of semiconductor material; a doped semiconductor layer of the other conductivity type which layer is sufficiently thin to be substantially fully depleted; and a second doped semiconductor layer of said one conductivity type; wherein the doping density of said first doped semiconductor layer is different from the doping density of said second doped semiconductor layer.

A layer intermediate layer of semiconductor material may be disposed between said doped semiconductor layer of other conductivity type and said second doped semiconductor layer.

Third and fourth layers of semiconductor material of said one conductivity type and of greater doping density than said first and second doped semiconductor layers may be disposed in contact with said first and second semiconductor layers, respectively, to provide electrical contact thereto.

An embodiment of the invention will now be described, by way of example, with reference to the accompanying drawing, in which

Figure 1 shows a schematic cross section through a semiconductor device incorporating a planar doped barrier structure in accordance with the invention,

Figure 2 is a schematic doping profile of the barrier structure of Figure 1, and

Figure 3 is a schematic profile of the electron potential energy of the barrier structure of Figure 1.

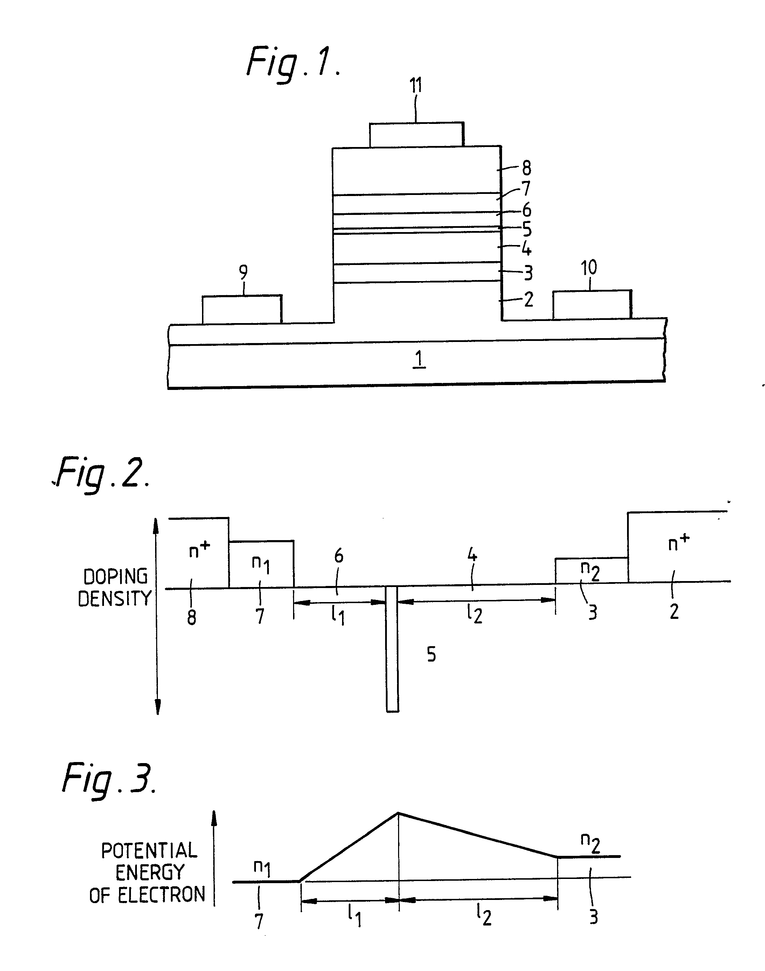

Referring to Figure 1, a semiconductor device comprises a substrate 1 of, for example, gallium arsenide on which is epitaxially grown a heavily-doped $n^+$ layer 2 to provide electrical contact to the barrier structure which is formed thereon. The layer 2 may typically be a few microns thick and may be doped to a density in the range of, for example, 3 to 4 x $10^{18}$/cm³. An n-type layer 3, which may be of a few thousand Angstroms thickness, is grown on the layer 2. The layer 3 may be doped to a density in the range of, for example, $10^{17}$ to 3 x $10^{18}$/cm³. A substantially undoped semiconductor layer 4 of up to about 0.5 micron thickness is then grown on the layer 3. A p-type layer 5 of some 10-500Å thickness and of doping density in the range of, for example, $10^{17}$ to $10^{19}$/cm³ is then grown on the layer 4, followed by a substantially undoped layer 6 of up to, say, 0.5 micron thickness. A second n-type layer 7 of a few thousand Angstroms thickness is then grown on the layer 6, the layer 7 having a doping density in the range of, for example, $10^{17}$ to 3 x $10^{18}$/cm³. A heavily-doped $n^+$ layer 8 is grown thereon to act as an ohmic contact. This layer may be, for example, around 1 micron thick, and may have a doping density of, say, 3 or 4 x $10^{18}$/cm³.

The sides of the layer structure are then etched down into the layer 2, and metallic contacts 9 and 10 are deposited on the exposed regions of the layer 2. A further metallic contact 11 is deposited on the layer 8.

The layers 3-7, inclusive, form a planar doped barrier structure. Structures of the type so far described are already known, but in all of the known devices the doping density of the layer 7 has been the same as the doping density of the layer 3. This has resulted in a potential profile which is symmetrical from the point of view of barrier height.

In the structure of the present invention, on the other hand, the doping densities of the layers 3 and 7 are made significantly unequal. The same doping density ranges are quoted above for the two layers, but the values for the layers will be chosen from those ranges such as to give the required inequality. The layer 5 is made sufficiently thin to be substantially fully depleted. A schematic doping profile is shown in Figure 2 for the various layers. The doping density of the layer 7 is shown as being greater than that of the layer 3. This will result in an electron potential energy profile as shown in Figure 3. It will be seen that the potential energy level at the right hand side of the barrier is higher than that at the left hand side. This indicates an extremely important difference from the known devices. for which the potential energy levels at the two sides of the barrier would be equal.

Clearly, the relative doping densities of the layers 3 and 7 could be reversed, so that that of the layer 3 is greater than that of the layer 7.

The effect of the asymmetric doping of the layers therefore produces, in effect, a built-in voltage similar to that found in Schottky diodes and p-n junctions. The structure of the present invention therefore combines advantages of such devices with advantages of the convention planar doped barriers. For example, because the effective barrier height at zero bias is now appreciably smaller on one side of the barrier than the other, the forward characteristic of a diode structure can be significantly improved without necessarily changing the reverse characteristic to any large extent. It is not possible to effect such improvement using the equal doping densities of the conventional planar doped barrier structures.

Suitable selection of the doping densities of the layers 3 and 7 allows the ideality (n) of the current-voltage (I-V) characteristic to be improved. The ideality is a figure of merit which is well-known in the context of Schottky barriers and is given by

$$n = \frac{q}{kT} \frac{d|V|}{d \log J}$$

where $V \gg \frac{kT}{q}$
q = electronic charge
T = absolute temperature
V = voltage
J = current density

Furthermore, the curvature of the current-voltage (I-V) characteristic at the origin (proportional to $d^2I/dV^2$) can be improved as a result of the asymmetrical doping. Such improvement is not possible in a conventional planar doped barrier structure.

This improvement has important consequences for devices which are based on the planar doped barrier configuration, such as zero bias detectors and low-drive mixers, the performance of which can be improved by simply adjusting the relationship between the doping densities of the layers 3 and 7.

A number of modifications of the structure described above may be made. For example either, but not both, of the substantially undoped intermediate semiconductor layers 4 and 6 may be omitted.

On the other hand, either or both of the intermediate semiconductor layers 4 and 6 may be lightly doped n-type, at a density in the range of, for example, $10^{15}$ to $5 \times 10^{16}/cm^3$. This will reduce the overall resistance of the device under high applied bias voltages. The doping of either or both of the intermediate layers 4 and 6 might by graded in either direction through the thickness of the layer. Furthermore, the doping of either or both of the intermediate layers may increase through a first part of its thickness and then decrease through a second part of the thickness, so that a "humped" doping density curve results.

If the doping density of either of the layers 3 and 7 is sufficiently high, the respective additional contact layer 2 or 8 could be omitted.

An $n^+$ doped substrate might be used, in which case the layer 2 could be omitted.

Although gallium arsenide is suggested above as a suitable basic material for the structure, any other material, such as silicon, indium phosphide or indium arsenide, which can be grown epitaxially and which can be doped to give layers of opposite conductivity types could be used. Any epitaxial growth process may be used, such as molecular beam epitaxy or chemical vapour deposition.

Although the doping profile of Figure 2 shows vertical steps between the various layers, it may be more convenient to provide more gradual transitions between layers.

It will be apparent that although the layers 2, 3, 7 and 8 are shown, by way of example, as n-type material and the layer 5 as p-type, the conductivity types could be reversed.

The relative widths of the intermediate layers 4 and 6 can be selected to position the peak of the profile in Figure 3.

## Claims

1. A planar doped barrier structure, characterised by, in a stack, a first doped semiconductor layer (3) of one conductivity type; an intermediate layer (4) of semiconductor material; a doped semiconductor layer (5) of the other conductivity type which layer is sufficiently thin to be substantially fully depleted; and a second doped semiconductor layer (7) of said one conductivity type; wherein the doping density of said first doped semiconductor layer is different from the doping density of said second doped semiconductor layer.

2. A structure as claimed in Claim 1, characterised by a further intermediate layer (6) of semiconductor material disposed between said doped semiconductor layer (5) of other conductivity type and said second doped semiconductor layer (7).

3. A structure as claimed in Claim 1 or Claim 2, characterised in that either or both of said intermediate layer (4) and said further intermediate layer (6) is or are substantially undoped.

4. A structure as claimed in Claim 1 or Claim 2, characterised in that either or both of said intermediate layer (4) and said further intermediate layer (6) is or are slightly doped to be of said one conductivity type.

5. A structure as claimed in Claim 4, characterised in that either or both of said intermediate layer (4) and said further intermediate layer (6) is or are doped with a density which varies through the thickness of the layer.

6. A structure as claimed in Claim 5, characterised in that either or both of said intermediate layer (4) and said further intermediate layer (6) is or are doped with a density which increases through a first part of the thickness of the layer and decreases through a second part of the thickness.

7. A structure as claimed in any preceding claim, characterised by third and fourth layers (2,8) of semiconductor material of said one conductivity type and of greater doping density than said first and second doped semiconductor layers, disposed in contact with said first and second semiconductor layers (3,7), respectively, to provide electrical contact thereto.

8. A structure as claimed in any preceding claim, characterised in that the layers (2-8) are formed epitaxially.

9. A structure as claimed in any preceding claim, characterised in that the layers (3,7) of said one conductivity type are n-type layers and the layer (5) of the other conductivity type is a p-type layer.

10. A structure as claimed in any preceding claim, characterised in that the basic material of the layers (2-8) is selected from gallium arsenide, silicon, indium phosphide and indium arsenide.

11. A semiconductor device including a planar doped barrier structure (2-8) as claimed in any preceding claim.

12. A method of forming a planar doped barrier structure, characterised by the steps of depositing a first layer (3) of doped semiconductor material of one conductivity type; forming thereover an intermediate layer (4) of semiconductor material; forming a substantially fully-depleted layer (5) thereover of doped semiconductor material of the other conductivity type; and forming thereover, or on a further intermediate layer (6) of semiconductor material deposited thereover, a second layer (7) of doped semiconductor material of said one conductivity type and of different doping density from said first doped semiconductor layer.

13. A method as claimed in Claim 12, characterised in that said intermediate layer (4) and/or said further intermediate layer (6) is substantially undoped.

14. A method as claimed in Claim 12, characterised in that said intermediate layer (4) and/or said further intermediate layer (6) is slightly doped and is of said one conductivity type.

15. A method as claimed in Claim 14, characterised in that said intermediate layer (4) and/or said further intermediate layer (6) is slightly doped with a density which varies through the thickness of the layer.

16. A method as claimed in Claim 15, characterised in that said intermediate layer (4) and/or said further intermediate layer (6) is slightly doped with a density which increases through a first part of said thickness and decreases through a second part of said thickness.

Fig.1.

Fig.2.

DOPING DENSITY

Fig.3.

POTENTIAL ENERGY OF ELECTRON